# EUROPÄISCHE PATENTANMELDUNG

(11) **EP 4 827 273 A2**
(43) Veröffentlichungstag der Anmeldung: **21.10.2026**
(21) Anmeldenummer: 26197229.3
(22) Anmeldetag: 27.06.2024
(51) Int. Cl.: H10D 62/83

(54) **VERFAHREN ZUR HERSTELLUNG EINES FELDEFFEKTTRANSISTORS MIT EINER GEWÜNSCHTEN SCHWELLENSPANNUNG**

(30) Priorität: 30.06.2023 DE 202023103661 U; 30.06.2023 DE 102023117399; 24.08.2023 DE 202023104831 U; 24.08.2023 DE 102023122775
(62) Dokumentnummer(n) der früheren Anmeldung(en) nach Art. 76 EPÜ: 24185042.9 / 4 484 942
(71) Anmelder: AMO GmbH, 52074 Aachen (DE); Rheinisch-Westfälische Technische Hochschule (RWTH) Aachen Körperschaft des öffentlichen Rechts, 52062 Aachen (DE)
(72) Erfinder: Esteki, Ardeshir, 52062 Aachen (DE); Lemme, Max, 51069 Koln (DE); Daus, Alwin, 52064 Aachen (DE)
(74) Vertreter: Patentanwälte Bauer Vorberg Kayser

(57) **Zusammenfassung**

Die vorliegende Erfindung betrifft einen Feldeffekttransistor.

## Beschreibung

Die vorliegende Erfindung betrifft einen Feldeffekttransistor. Ein Feldeffekttransistor ist in seinem grundsätzlichen Aufbau bekannt. So weist dieser folgende Komponenten auf: eine auf einem Substrat angeordnete Kanalschicht, eine Source und Drain, wobei die Source und Drain an die Kanalschicht angrenzend angeordnet sind, eine dielektrische Schicht, die auf einer dem Substrat abgewandten Seite der Kanalschicht angeordnet ist, sowie ein Gate.

Ein anhaltender Trend bei der Entwicklung von Feldeffekttransistoren ist die Verwendung von sog. 2D-Materialien zur Ausbildung der zwischen Source- und Drain angeordneten Kanalschicht. Derartige 2D-Materialien können beispielsweise vorteilhaft für Feldeffekttransistor-Applikationen in der elektrischen Sensorik sein. Typische 2D-Materialien sind Graphen und seine Derivate sowie Übergangsmetall-Dichalkogenide. Feldeffekttransistoren auf Basis von Graphen, sog. G-FETs, sind aus dem Stand der Technik bekannt.

Bei Sensorik-Anwendungen können zu erfassende Analyten z. B. durch ihre Anlagerung oder Wechselwirkung an bzw. mit einer Komponente des Feldeffekttransistors zu einem Dotierungs-Effekt in der Kanalschicht führen. Die Dotierung kann entweder vom p-Typ oder vom n-Typ sein, abhängig von den relativen Energieniveaus des Analyten und der Kanalschicht. Bei 2D-Halbleitermaterialien können Dotierungsänderungen das Fermi-Niveau und die Austrittsarbeit des Materials verändern, wodurch sich die Höhe der Schottky-Barriere zwischen dem Halbleiter und den Metallelektroden ändert. Diese Änderung führt wiederum zu einer Änderung der Gesamtleitfähigkeit des Bauelements.

Es werden verschiedene Bauelementarchitekturen für die elektrische Sensorik unter Verwendung von 2D-Materialien erforscht, z. B. Chemowiderstände, chemische Kondensatoren, chemische Dioden und Feldeffekttransistoren (FETs). Unter diesen sind die FET-Implementierungen besonders interessant, da sie als leicht integrierbar in die bestehenden Halbleiterherstellungstechnologien angesehen werden können. Darüber hinaus bietet der Gate-Anschluss in FET-Designs eine zusätzliche Ansatzstelle zur Steuerung der Ladungsträger-Mobilität, wodurch sie im Vergleich zu anderen Bauelementfamilien eine höhere Empfindlichkeit erreichen.

Feldeffekttransistoren werden freilich nicht nur bei Sensorik-Anwendungen eingesetzt. Je nach Aufbauprinzip (Sperrschichtfeldeffektransistoren vs. Isolierschichtfeldeffekttransistoren) können unterschiedliche Applikationen zugänglich sein. Beispielsweise können Feldeffekttransistoren (insbesondere Isolierschichtfeldeffekttransistoren) in integrierten Schaltungen eingesetzt werden. Anwendungsgebiete reichen ferner von der Digitaltechnik bis zur Hochfrequenztechnik.

Wie einleitend in der Publikation EP 2 790 227 A1 beschrieben, ist die Entwicklung von Materialien mit hoher Dielektrizitätskonstante (hohes k = High-k) zur Verwendung als Dielektrikum in der dielektrischen Schicht eines Feldeffekttransistors von eminenter Bedeutung für dessen Eigenschaften. Wie in der EP 2 790 227 A1 ausgeführt, sollten derartige dielektrische Schichten ultradünn, konform und frei von Nadellöchern sein, dazu eine minimale Unordnung oder Fallen an der dielektrischen Grenzfläche zur Kanalschicht aufweisen. Wie in EP 2 790 227 A1 beschrieben, ist eine geeignete Methode für die kontrollierte Abscheidung ultradünner homogener Schichten die sog. Atomlagenabscheidung (ALD). Die ALD von dünnen Schichten auf 2D-Materialschichten wie Graphen ist jedoch technisch komplex, da auf der inerten Oberfläche des Graphens keine funktionellen Oberflächengruppen oder Defekte vorhanden sind, die für die chemischen Oberflächenreaktionen benötigt werden, auf denen die herkömmlichen ALD-Verfahren basieren. Es besteht somit ein wachsendes Interesse an der Entwicklung von geeigneten Abscheidungsverfahren von High-k Materialien auf aus 2D-Materialien gebildeten Schichten.

Aus US 2017/0077261 A1 ist ein Graphen-basierter Feldeffekttransistor (GFET) bekannt.

Aus US 2014/145269 A1 ist ein Feldeffekttransistor bekannt, welcher ein Halbleitersubstrat, ein darauf angeordnetes Back-Gate aus Silber und Silberoxid und eine Siliziumschicht als Kanalschicht aufweist. Auf der Siliziumschicht ist eine dielektrische Schicht angeordnet und ein Top-Gate.

Neben der Verwendung von Graphen als in Feldeffekttransistoren zum Einsatz kommendem 2D-Material (sog. G-FETs), gewinnen auch Feldeffekttransistoren auf Basis von Molybdän-Disulfid (MoS2) an Bedeutung z.B. bekannt aus Lee Tsu-Ting et al., Journal of Nanosciences Research and Reports, 2022-01-01, 1-6 oder Sebastian Amritanand et al., Nature Communications, 2021 12(1*).* Nebst Anwendungen bei integrierten Schaltungen, wurden vielseitige Anwendungen gefunden, die vom Nachweis nanometrischer Biomoleküle bis hin zum Einsatz in Hochleistungsrechnern reichen. Im Vergleich zu konventionellen Bauelementen auf der Basis von Silizium und seinen Derivaten, weisen Transistoren, die mit MoS2 realisiert werden, w teils verbesserte Eigenschaften auf, beispielsweise einen geringen Stromverbrauch. Daher eignen sich MoS2 Feldeffekttransistoren nicht nur für die Realisierung von Hochleistungselektroniksystemen mit geringem Stromverbrauch, sondern auch für Sensormodule zur Erkennung verschiedener physikalischer, chemischer und biologischer Analyten sowie für Displays.

Ein wichtiger Parameter eines Feldeffekttransistors ist die sogenannte Schwellenspannung. Eine flexible Einstellbarkeit der Schwellenspannung kann beispielsweise anwendungsspezifische oder bauteilspezifische Vorteile, z. B. mit Blick auf den Energieverbrauch, haben. Aus dem Stand der Technik sind unterschiedliche Methoden zur Anpassung der Schwellenspannung in Feldeffektransistoren bekannt. Es sei diesbezüglich auf die folgenden wissenschaftlichen Publikationen verwiesen: Wittmann et al., ACS Applied Electronic Materials 2020 2(5), 1235-1242*;* Gun Oh et al., Appl. Phys. Lett. 99, 193503 (2011*);* Solis-Fernandez et al., ACS Nano 2016, 10, 2, 2930-2939*;* Wei et al., Nano Lett. 2013, 13, 5 1890-1897 *;* Guo et al., Nano Lett. 2010, 10, 12, 4975-4980*.* Diese Verfahren sind in der Regel mit einem relativ hohen technischen Aufwand verbunden, was die Anwendbarkeit in der Großserienfertigung limitiert.

In Graphen-FETs (GFETs) entspricht die Schwellenspannung der Ladungsneutralität oder der Dirac-Spannung (V_{Dirac}) als der Gatespannung, bei der der Strom sein Minimum hat.

Entsprechend liegt der vorliegenden Erfindung die Aufgabe zugrunde, einen Feldeffekttransistor vorzuschlagen, bei dem sich eine Schwellenspannung maßgeschneidert und vereinfacht einstellen lässt.

Zur Lösung dieser Aufgabe wird ein Feldeffekttransistor vorgeschlagen.

Zunächst betrifft die vorliegende Erfindung ein Verfahren zur Herstellung eines Feldeffekt-Transistors mit einer gewünschten Schwellenspannung, umfassend die folgenden Schritte:
a. Festlegen der gewünschten Schwellenspannung;
b. Bereitstellen eines Substrats;
c. Anordnen einer Source und Drain auf dem Substrat;
d. Erzeugen eines 2D-Materials;
e. Transferieren des 2D-Materials auf das Substrat, wobei das 2D-Material beim Transferieren mit einer Schutzschicht bedeckt wird,
f. Strukturieren des 2D-Materials unter Ausbildung einer Kanalschicht;
g. Aufbringen einer dielektrischen Schicht aus einem High-k-Material auf einer dem Substrat abgewandten Seite der Kanalschicht;
h. Bereitstellen eines Gates;
wobei die gewünschte Schwellenspannung eingestellt wird durch
i. Auswählen einer Schichtdicke (d) mit der die dielektrische Schicht im Schritt g. aufgebracht wird, wobei das Auswählen der Schichtdicke (d) unter Berücksichtigung eines Schichtdicken-Schwellenspannung Proportionalzusammenhangs erfolgt.

Wie erwähnt, betrifft Schritt a. eines erfindungsgemäßen Verfahrens die Festlegung einer gewünschten Schwellenspannung. Die "gewünschte" (also im hergestellten Feldeffekttransistor zu verwirklichende) Schwellenspannung kann aufgrund eines Kundenwunsches, aufgrund einer für eine bestimmte Applikation zu erfüllenden Schwellenspannungs-Anforderung, oder aus anderen Gründen vorgegeben sein. Die "Festlegung der gewünschten Schwellenspannung" kann als Zielwertvorgabe eines Werts der Schwellenspannung zu verstehen sein, wobei es Ziel der Herstellung ist, diese vorab (d.h. vor Beginn des körperlichen Herstellungsverfahrens) festzulegen und sodann durch entsprechende Herstellung im hergestellten Feldeffekttransistor zu verwirklichen. Im verfahrensgemäß hergestellten Feldeffekttransistor muss die Zielwertvorgabe des Werts der Schwellenspannung (bis auf vorgegebene Toleranzgrenzen von beispielsweise 0.01 - 1 %, maximal 0.01 bis 5 %) mit der tatsächlich verwirklichten Schwellenspannung übereinstimmen. Die Zielwertvorgabe der Schwellenspannung kann vom Material, der Größe, von der Form und vom Aufbau einzelner oder mehrerer Bestandteile des Feldeffekttransistors abhängig sein, sodass derartige Parameter bei der Festlegung oder Ermittlung der gewünschten Schwellenspannung zu berücksichtigen sind. Gleichermaßen kann die Wechselwirkung des Feldeffekttransistors mit Umgebungsbedingungen (Temperatur, Druck, Luftfeuchtigkeit etc.) einen Einfluss auf die Festlegung der Schwellenspannung haben. Ebenso kann die Applikation, in welcher der herzustellende Feldeffekttransistor zum Einsatz kommen soll, die Festlegung bzw. Zielwertvorgabe der Schwellenspannung beeinflussen. Die Festlegung der gewünschten Schwellenspannung kann rechnerisch (manuell und/oder automatisiert) und/oder im Wege einer Simulation ermittelt werden. Eine Simulation kann auf Basis einer Rechenroutine, eines Algorithmus, eines Simulationscodes, und/oder auf Basis von künstlicher Intelligenz durchgeführt werden. Die Simulation kann auf Basis einer finite Elemente Methode erfolgen.

Auch kann die Festlegung der gewünschten Schwellenspannung auf Basis von Testergebnissen erfolgen bzw. Testergebnisse können dabei berücksichtigt werden. Mit Testergebnissen können Tests, d.h. experimentelle Untersuchungen, einzelner Bestandteile des Feldeffekttransistors oder an vorab hergestellten Feldeffekttransistoren (z. B. Prototypen) gemeint sein. Tests, d.h. experimentelle Untersuchungen, können insbesondere Tests zur Charakterisierung von typischen Eigenschaften (z. B. elektrischen Eigenschaften) einzelner Bestandteile des Feldeffekttransistors oder an vorab hergestellter Feldeffekttransistoren zu verstehen sein. Es können beispielsweise Prototypen von Feldeffekttransistoren mit variierenden oder unterschiedlichen Eigenschaften (z. B. auch Größenverhältnissen, Formvariationen etc.). bereitgestellt werden, die sodann im Wege einer Testreihe hinsichtlich bestimmter Charakteristika oder Eigenschaften untersucht werden. Auf Basis dieser Testergebnisse kann ebenfalls eine gewünschte Schwellenspannung festgelegt werden. Ferner können Prototypen von Feldeffekttransistoren oder auch bereits hergestellte Feldeffekttransistoren bei bestimmten Applikationen oder unter bestimmten Bedingungen in Feldversuchen getestet werden. Die dabei gewonnenen Erkenntnisse können ebenfalls zur Festlegung der Schwellenspannung herangezogen werden.

Letztlich ist es auch möglich, die gewünschte Schwellenspannung auf Basis von Literaturwerten, Kalibrier-Testreihen oder auf Basis von Erfahrungswerten festzulegen.

Wie erwähnt, betrifft Schritt b. eines erfindungsgemäßen Verfahrens die Bereitstellung eines Substrats. Eine "Bereitstellung" eines Substrats kann dabei eine Anordnung eines Substrats in einer Herstellungsvorrichtung umfassen, d.h. eine Anordnung des Substrats in einer Substrat-Trägervorrichtung, einer Substrat-Aufnahme oder einer Substrat-Haltevorrichtung. Das Substrat kann ein Flachkörper sein, insbesondere eine Dünnschicht. Das Substrat kann eine Bauteil-Basis des Feldeffekttransistors bilden, d.h. es stellt einen Grundkörper oder einen Träger für die weiteren Komponenten des Feldeffekttransistors bereit. Unabhängig davon, ob es sich bei dem Substrat um einen Flachkörper wie eine Dünnschicht handelt oder nicht, kann das Substrat eine beliebige Kontur-Form (Grundform) aufweisen. Dies meint, dass das Substrat beispielsweise eine rechteckige, quadratische, kreisförmige, elliptische, ovale oder anderweitige Grundform aufweisen kann. Das Substrat kann eine glatte Oberfläche aufweisen, jedoch auch profiliert sein, d.h. eine vorgegebene Rauheit aufweisen.

Wie erwähnt, betrifft Schritt c. eines erfindungsgemäßen Verfahrens die Anordnung einer Source (Quelle, Zufluss) und Drain (Senke, Abfluss) auf dem Substrat. Bei einer solchen "Anordnung" kann es sich um ein chemisches, physikalisches oder physikalisch-chemisches Abscheidungsverfahren handeln. Bei der Source und Drain handelt es sich vorzugsweise um Elektroden, also eine Source-Elektrode und Drain-Elektrode. Die Source und Drain können jeweils mit einem geeigneten Kontaktier-Element elektrisch kontaktiert werden. Die Steuerung eines nach dem hiesigen Verfahren herstellbaren Feldeffekttransistors erfolgt über die am Gate anlegbare (und variierbare) Gate-Spannung (gemäß Schritt h. wird ein Gate bereitgestellt), was aus dem Stand der Technik wohlbekannt ist. Das Gate ist mittels eines dielektrischen Materials von der Kanalschicht getrennt, wobei dies unabhängig von der konkreten Verschaltungsgeometrie (z. B. einer Top-Gate Konfiguration oder einer Back-Gate Konfiguration ist). Bei einer Back-Gate Konfiguration beispielsweise kann das Substrat das besagte dielektrische Material bereitstellen, während dieses bei einer Top-Gate Konfiguration von der eingangs erwähnten dielektrischen Schicht bereitgestellt wird. Die Funktionalität derart geschalteter FETs ist aus dem Stand der Technik bekannt und sei an dieser Stelle nicht wiederholt.

Gemäß Schritt d. wird zunächst ein 2D-Material erzeugt. Das 2D-Material kann dabei auf einem Trägersubstrat (dieses kann auch als Wachstumssubstrat bezeichnet werden) erzeugt werden. Im Schritt e. wird das 2D-Material auf das Substrat (des Feldeffekttransistors) transferiert. Das 2D-Material wird also zunächst extern bzw. separat vom Substrat erzeugt und sodann (nach dessen Erzeugung) auf das Substrat übertragen. Unter einer "externen bzw. separaten" Erzeugung kann eine räumlich getrennte Erzeugung verstanden werden, d.h. das 2D-Material wird nicht in-situ auf dem Substrat erzeugt, sondern zunächst örtlich separat zum Substrat erzeugt und sodann auf dieses transferiert. Das Transferieren kann einen Trockentransfer (engl. "dry transfer") betreffen.

2D-Materialien weisen im Vergleich zu ihrer lateralen Ausdehnung (z. B. in einer Ebene) eine wesentlich geringere Höhe (bzw. Schichtdicke oder Lagendicke) auf. 2D-Materialien sind Materialien, vorzugsweise kristalline Materialien, die vorzugsweise aus nur einer Lage von Atomen oder Molekülen aufgebaut sind. Handelt es sich bei dem 2D-Material um eine Lage aus Atomen, so können jene die Lage ausbildenden Atome dieselbe Art von Elementen umfassen, z. B. das Element Kohlenstoff bei Graphen als 2D-Material. Handelt es sich bei dem 2D-Material um eine Lage aus Molekülen, so kann es sich bei den die Lage ausbildenden Molekülen um dieselbe Art von Molekülen handeln. Gleichsam kann ein 2D-Material aber auch Atome (bzw. Elemente) und/oder Moleküle verschiedener Art umfassen. Im vorliegenden Kontext kann auch ein aus mehreren Materiallagen gebildetes Material als 2D-Material verstanden werden, solange dessen laterale Ausdehnung größer als dessen Schicht- oder Lagendicke ist.

Wie erwähnt, wird das 2D-Material beim Transferieren mit einer Schutzschicht bedeckt. Die Schutzschicht schützt - wie dem Begriff "Schutzschicht" bereits zu entnehmen ist - das erzeugte 2D-Material beim Transferieren auf das Substrat vor äußeren Einflüssen, beispielsweise einer Kontamination mit Umgebungsstoffen wie Feuchtigkeit, Staub, Partikeln etc. Zudem kann die Schutzschicht das 2D-Material beim Transfer körperlich stützen, z. B. im Sinne einer Stützstruktur. Ebenfalls kann die Schutzschicht das 2D-Material gemeinsam mit einem Trägersubstrat (zum Transfer des 2D-Materials) einbetten. Die Schutzschicht kann auch selbst das Trägersubstrat bereitstellen und ein- oder beidseitig auf das 2D-Material aufgebracht sein. In jenem Falle, dass die Schutzschicht das Trägersubstrat bereitstellt, kann die Schutzschicht dahingehend ausgebildet sein, dass das 2D-Material an der Schutzschicht haftet oder die Schutzschicht am 2D-Material haftet. Bei der Schutzschicht kann es sich beispielsweise um eine Schutzfolie handeln. Die Schutzschicht kann bereits vorgefertigt sein und im Sinne eines eigenständigen Bauteils auf das 2D-Material aufgebracht bzw. positioniert werden. Es kann aber auch vorgesehen sein, die Schutzschicht unmittelbar auf dem bereits erzeugten 2D-Material zu erzeugen oder abzuscheiden, also auf der Grenzfläche des 2D-Materials zur Umgebung. Beispielsweise kann die Schutzschicht im Wege eines Spin-Coating Verfahrens auf dem 2D-Material aufgebracht werden. Bei Verwendung einer Schutzschicht kann die Ausbeute von auf das Substrat transferierten 2D-Material merklich gesteigert werden. Defekte und Artefakte im 2D-Material können - wie auch im allgemeinen Beschädigungen des 2D-Materials - reduziert werden.

Wie erwähnt, betrifft Schritt f. eines erfindungsgemäßen Verfahrens das Strukturieren des 2D-Materials unter Ausbildung einer Kanalschicht. Erst die Kanalschicht ermöglicht einen Ladungstransport (durch Elektronen oder Löcher) zwischen Source und Drain im Feldeffekttransistor. Die Strukturierung kann insbesondere einen Materialabtrag von 2D-Material umfassen, um die gewünschte Struktur und Form der Kanalschicht auszubilden, d. h. an bestimmten Stellen wird 2D-Material abgetragen (entfernt) und an anderen Stellen wird kein 2D-Material entfernt (das 2D-Material verbleibt an diesen Stellen). Durch die gezielte Entfernung bzw. den gezielten Verbleib von 2D-Material kann somit eine gewünschte Struktur ausgebildet werden. Die Strukturierung kann beispielsweise unter Einsatz einer Maske erfolgen, wobei das 2D-Material beim Strukturieren in jenen Bereichen mit der Maske abgedeckt wird, in denen kein Materialabtrag erfolgen soll. In jenen Bereichen, in denen eine Strukturierung erfolgen soll, liegt das 2D-Material entweder frei oder ist mit einem Material bedeckt, welches beim Strukturieren ebenfalls entfernt wird. Die Maske kann also in bestimmten Bereichen den Abtrag von 2D-Material gezielt verhindern. Die Strukturierung kann einen oder mehrere Verfahrensschritte umfassen. Der eine oder die mehreren Verfahrensschritte können abtragend (in Bezug zum 2D-Material sein). Es kann aber auch vorgesehen sein, dass einer oder mehrere der mehreren Verfahrensschritte nicht abtragend sind. Die Strukturierung bzw. zumindest einer der im Wege der Strukturierung stattfindenden Verfahrensschritte kann eine Mikrostrukturierung betreffen. Die Strukturierung bzw. zumindest einer der im Wege der Strukturierung stattfindenden Verfahrensschritte kann ein Lithographie-Verfahren umfassen. Als beispielhafte Lithographie-Verfahren seien die Photo-, Laser- oder Elektronenstrahllithographie genannt. Die Strukturierung kann beispielsweise ein Ätzverfahren, z. B. Trockenätzen, umfassen. Als Beispiel für ein im Rahmen der Erfindung besonders geeignetes Strukturierverfahren sei das Trockenätzen genannt, insbesondere das RIE ("reactive ion etching") Verfahren. Gegebenenfalls kann auch ein nasschemisches Abtrage- bzw. Ätzverfahren zur Strukturierung zum Einsatz kommen. Eine Abtragung mittels eines geeigneten Lösungsmittels ist ebenfalls denkbar. Die Strukturierung kann eine Vorbehandlung oder Nachbehandlung umfassen. Es können auch mehrere der vorgenannten Verfahren bei der Strukturierung zum Einsatz kommen.

Wie erwähnt, betrifft Schritt g. eines erfindungsgemäßen Verfahrens das Aufbringen einer dielektrischen Schicht aus einem High-k-Material auf einer dem Substrat abgewandten Seite der Kanalschicht. Als "High-k" Material können Materialien bezeichnet werden, die eine höhere Dielektrizitätszahl aufweisen als herkömmliches Siliziumdioxid. Grundsätzlich ist die Aufbringung von Materialien (egal welcher Art) auf der aus einem 2D-Material gebildeten Kanalschicht technisch anspruchsvoll. Augenmerk liegt dabei darauf, dass das 2D-Material nicht beschädigt wird. Die Erfinder haben gezeigt, dass eine dielektrische Schicht aus einem High-k Material besonders schonend (in Bezug auf das 2D-Material) im Wege eines sog. PEALD (Plasma-enhanced atomic layer deposition) Verfahrens auf die Kanalschicht aufgebracht werden kann. Mittels dieses Verfahrens lässt sich die Schichtdicke der dielektrischen Schicht zuverlässig und präzise einstellen.

Wie erwähnt, betrifft Schritt h. eines erfindungsgemäßen Verfahrens die Bereitstellung eines Gates, beispielweise in Top-Gate oder Back-Gate Konfiguration. Beim Gate handelt es sich vorzugsweise um eine Gate-Elektrode. Das Top-Gate ist vorzugsweise aus einem Metall gefertigt. Das Top-Gate ist vorzugsweise auf der dielektrischen Schicht angeordnet. Das Top-Gate kann dabei mittels eines geeigneten Abscheideverfahrens auf der dielektrischen Schicht aufgebracht werden.

Wie im Schritt i. zum Ausdruck kommend, wird bei einem Verfahren gemäß der Erfindung die gewünschte Schwellenspannung eingestellt durch Auswählen einer Schichtdicke mit der die dielektrische Schicht im Schritt g. aufgebracht wird, wobei das Auswählen der Schichtdicke unter Berücksichtigung eines Schichtdicken-Schwellenspannung Proportionalzusammenhangs erfolgt. Experimentelle Untersuchungen der Erfinder haben dabei überraschend gezeigt, dass sich die Schichtdicke der elektrischen Schicht (bei konstanter Bauteilgeometrie und konstanter Dimensionierung des Feldeffekttransistors) unmittelbar auf die Schwellenspannung des hergestellten Feldeffekttransistors auswirkt. Die Schichtdicke ist dabei proportional zur Schwellenspannung (Schichtdicken-Schwellenspannung Proportionalzusammenhang). Die Schichtdicke beeinflusst dabei die Dotierung der Kanalschicht. Somit kann bereits durch die Herstellung als solche, bzw. Betriebsparameter bei der Herstellung, eine gewünschte Schwellenspannung eines herzustellenden Feldeffekttransistors eingestellt werden. Ein solches Prozedere ist einfach umzusetzen und eignet sich aufgrund seiner Simplizität für die Großserienherstellung.

Freilich können auch andere Bestandteile des Feldeffekttransistors dessen Schwellenspannung beeinflussen. Jedoch hat sich experimentell gezeigt, dass bei "Konstant-halten" weiterer Parameter des Feldeffekttransistors (also seiner Größendimensionen, der Schichtdicken der einzelnen Bestandteile, bei Verwendung identischer Materialien etc., also bei konstantem Gesamt-Layout), die Schwellenspannung durch Variation der Schichtdicke der dielektrischen Schicht eingestellt werden kann. Die Schwellenspannung ist also erfindungsgemäß in-situ, d.h. unmittelbar bei der Herstellung des Feldeffekttransistors, einstellbar. Eine nachträgliche Anpassung der Schwellenspannung kann somit entbehrlich werden.

Weitere Ausgestaltungen der Erfindung sind in den Unteransprüchen sowie in der nachfolgenden Beschreibung der in den Unteransprüchen angegebenen Merkmale beschrieben. Ferner sind nachfolgend auch weitere - nicht in den Unteransprüchen angegebene - Merkmale beschrieben, die ebenfalls Ausgestaltungen der Erfindung sein können. Die nachfolgend angegebenen Merkmale können die Erfindung Kategorie-übergreifend spezifizieren, also unabhängig davon, ob es sich um ein Verfahren oder einen Feldeffekttransistor als solchen handelt.

Nach einer ersten Ausgestaltung der Erfindung kann vorgesehen sein, dass die Schutzschicht vorgelagert oder nachgelagert zum Strukturieren des 2D-Materials entfernt wird. Die hier verwendeten Termini "vorgelagert" und "nachgelagert" beziehen sich auf eine zeitliche Abfolge. Vorgelagert meint somit, dass die Schutzschicht in der Zeitdomäne vor der Strukturierung entfernt wird.

Nachgelagert meint, dass die Schutzschicht in der Zeitdomäne nach der Strukturierung entfernt wird. Eine zum Strukturieren vorgelagerte Entfernung der Schutzschicht meint, dass die Schutzschicht keine Strukturierung erfährt, bevor sie entfernt wird. Eine Entfernung der Schutzschicht nachgelagert zur Strukturierung meint, dass die Schutzschicht - wie auch die Kanalschicht - strukturiert wird.

Wird die Schutzschicht erst nach der Strukturierung entfernt, so kann diese die Kanalschicht, also das 2D-Material, während der Strukturierung schützen. Während der Strukturierung wird in der Regel Material - also auch 2D-Material der Kanalschicht - abgetragen. Die Schutzschicht kann dabei jenes nicht abzutragende 2D-Material der Kanalschicht schützen. Die Schutzschicht kann das 2D-Material in diesen Bereich somit generell vor äußeren Einflüssen bzw. vor mit der Strukturierung einhergehenden Einflüssen (z. B. Beschädigungen) protektieren. Wird die Schutzschicht (z. B. aus Kunststoff wie PMMA) nachgelagert zur Strukturierung entfernt, so kann damit die Menge von beim Strukturieren entstehenden Rückständen auf der dielektrischen Schicht reduziert werden.

Es kann beispielsweise vorgesehen sein, ein Material zur Verwendung als Schutzschicht auszuwählen, welches strukturierungsbeständig ist, d.h. die Schutzschicht wird bei einer abtragenden Strukturierung nicht abgetragen. Die Materialauswahl der Schutzschicht kann von dem konkret verwendeten Strukturierungsverfahren abhängen. Bei Strukturierungsverfahren, welche die Applikation elektromagnetischer Strahlung oder thermischer Energie zur Materialabtragung nutzen, kann ein Material als Schutzschicht ausgewählt werden, welches beständig gegenüber Bestrahlung mit elektromagnetischer Strahlung und gegenüber einem Eintrag von thermischer Energie (also hitzebeständig) ist. Es kann zudem vorgesehen sein, das Material der Schutzschicht dahingehend auszuwählen, dass diese das 2D-Material nicht schädigt.

Es kann vorgesehen sein, dass die Schutzschicht eine Materiallage umfasst. Ferner kann vorgesehen sein, dass die Schutzschicht mehrere Materiallagen desselben oder verschiedener Materialien umfasst. Es kann auch vorgesehen sein, auf der Schutzschicht eine oder mehrere zusätzliche Schutzschichten anzuordnen. Dies können beispielsweise Resistmaterialien betreffen, z. B. einen Lift-Off Resist und/oder einen AZ-Resist. Die eine oder mehreren zusätzlichen Schutzschichten können strukturierungsbeständig sein.

In jedem Falle wird die Schutzschicht und vorzugsweise werden auch die eine oder mehreren zusätzlichen Schutzschichten aus dem herzustellenden Feldeffekttransistor entfernt, d.h. sie verbleibt nicht im hergestellten Feldeffekttransistor.

Nach einer weiteren Ausgestaltung der Erfindung kann vorgesehen sein, dass ein Polymer, insbesondere PMMA (Polymethylmethacrylat), als Schutzschicht verwendet wird. Es kann beispielsweise vorgesehen sein, dass das 2D-Material mit einer Schutzschicht in Form einer Polymerfolie (z. B. einer Folie aus PMMA) bedeckt wird. Polymerfolien lassen sich besonders einfach und kostengünstig fertigen, ferner ist ihre Handhabung äußerst praktikabel. Es kann alternativ dazu vorgesehen sein, die Schutzschicht in-situ, d.h. unmittelbar auf der Oberfläche der Kanalschicht (also auf dem 2D-Material) zu fertigen, beispielsweise im Wege eines Spin-Coatings (Rotationsbeschichten). Dies ermöglicht eine die Schutzschicht in guter Anhaftung an das 2D-Material zu koppeln bzw. dieses mit der Schutzschicht zu bedecken. Ferner wird damit eine vollflächige und "dichte" Bedeckung gewährleistet. Leerstellen (also Stellen des 2D-Materials ohne Bedeckung mit der Schutzschicht) werden damit vermieden. Spin-Coating ermöglicht somit eine gleichmäßige (d. h. homogene) Auftragung der Schutzschicht auf dem 2D-Material. Auch andere Beschichtungsverfahren, insbesondere zur Abscheidung dünner Schichten (z. B. Sprühverfahren), können zum Aufbringen der Schutzschicht eingesetzt werden.

Nach einer weiteren Ausgestaltung der Erfindung kann vorgesehen sein, dass das High-k-Material der dielektrischen Schicht Aluminium, insbesondere Aluminiumoxynitrid, umfasst. Aluminiumoxynitrid ist ein transparenter keramischer Werkstoff, der die Elemente Aluminium, Sauerstoff und Stickstoff umfasst. Die Verwendung eines High-k-Materials auf Basis von Aluminium, insbesondere Aluminiumoxynitrid, hat sich als besonders vorteilhaft für eine gezielte schichtdickenabhängige Einstellung der Schwellenspannung erwiesen. Der Proportionalzusammenhang zwischen Schichtdicke und damit verbundener Schwellenspannung des Feldeffekttransistors, also letztlich der Dotierungseffekt der Kanalschicht, ist bei Verwendung eines High-k-Materials auf Basis von Aluminium, insbesondere bei Verwendung von Aluminiumoxynitrid, besonders ausgeprägt.

Nach einer weiteren Ausgestaltung der Erfindung kann vorgesehen sein, dass die dielektrische Schicht, insbesondere aus Aluminiumoxynitrid, in einem PEALD Verfahren aufgebracht wird. Das Akronym PEALD steht für eine Atomlagenabscheidung mit Plasmaunterstützung. Es kann beispielsweise vorgesehen sein, Aluminiumoxynitrid im Wege des besagten PEALD Verfahrens bei 200 °C in einem Stickstoffplasmaverfahren mit geringer Leistung unter Verwendung von Trimethylaluminium als Vorläufer abzuscheiden.

Nach einer weiteren Ausgestaltung der Erfindung kann vorgesehen sein, dass das Substrat eine Si-Schicht umfasst, wobei auf der Si-Schicht eine SiO₂-Schicht angeordnet ist, die bevorzugt eine Schichtdicke von 1 nm bis 200 nm, weiter bevorzugt eine Schichtdicke von 50 nm bis 150 nm, noch weiter bevorzugt eine Schichtdicke von 70 nm bis 120 nm und besonders bevorzugt eine Schichtdicke von 90 nm aufweist. Die Verwendung einer SiO₂-Schicht kann vorteilhaft für die Anhaftung der Kanalschicht auf dem Substrat sein, ggf. kann dies in einer Reduktion von Defekten in der auf der SiO₂-Schicht abgeschiedenen Kanalschicht führen. Die SiO₂-Schicht kann durch thermisches Aufwachsen auf der Si-Schicht angeordnet bzw. ausgebildet werden.

Die Schichtdicke der Si-Schicht (unabhängig von der darauf abgeschiedenen SiO₂-Schicht) wird dahingehend ausgewählt, dass sie für das zu fertigende Bauteil (also den Feldeffekttransistor) eine ausreichende mechanische Stabilität (als Substrat) bereitstellt. Gleichsam sollte die Schichtdicke aber auch dahingehend ausgewählt sein, dass einerseits der Materialeinsatz (Stichwort: Kosten) möglichst reduziert und die zu gewährleistenden Funktionalitäten (z. B. die Möglichkeit zur Kontaktierung der Si-Schicht mit einer Back-Gate Elektrode) erfüllt werden. Letztlich wird die Auswahl der Schichtdicke und Größe der Si-Schicht ein Trade-Off der vorgenannten Aspekte sein.

Anstelle der Si-Schicht kann auch eine Schicht aus einem anderweitigen Dielektrikum als Substrat verwendet werden. Das als Substrat verwendete Dielektrikum kann eine Oxidschicht aufweisen. Das Substrat alleine, die Oxidschicht alleine oder das Substrat in Kombination mit der Oxidschicht kann eine Schichtdicke von 1 nm bis 200 nm, weiter bevorzugt eine Schichtdicke von 50 nm bis 150 nm, noch weiter bevorzugt eine Schichtdicke von 70 nm bis 120 nm und besonders bevorzugt eine Schichtdicke von 90 nm aufweisen.

Nach einer weiteren Ausgestaltung der Erfindung kann vorgesehen sein, dass das 2D-Material Graphen oder Molybdändisulfid (MoS2) umfasst.

Grundsätzlich kann das 2D-Material auch andere Materialien umfassen bzw. aus diesen gebildet sein, z. B. anderweitige Übergangsmetall-Dichalkogenide wie MoS2 , WS2 , TaS2 , HfS2 , ReS2 , TiS2 , NbS2 , SnS2 , MoSe2 , WSe2 , TaSe2 , HfSe2 , ReSe2 , TiSe2 , NbSe2 , SnSe2 , MoTe2 , WTe2 , TaTe2 , HfTe2 , ReTe2 , TiTe2 , NbTe2 , und SnTe2.

Graphen ist ein Allotrop des Elementes Kohlenstoff aus der vierten Hauptgruppe des Periodensystems der Elemente. Kohlenstoff kann Bindungen mit sich selbst eingehen, woraus sich verschiedene Allotrope des Kohlenstoffes ergeben. Graphen ist eine monoatomare Lage reinen Kohlenstoffes, welcher in einer hexagonalen Bienenwabenstruktur gebunden ist. Eine Lage weist eine Dicke von ungefähr 3 Å = 0,3 nm auf. Demnach besitzt Graphen eine wesentlich geringere Höhe (Schichtdicke) im Vergleich zu seiner lateralen Ausdehnung, welche mehrere Millimeter betragen kann. Aus diesem Grund ist Graphen ein 2D-Material. Graphen kann vorteilhaft für eine Anwendung in Feldeffekttransistoren sein, da es eine hohe Stabilität in Bezug auf seine elektrischen, mechanischen und chemischen Eigenschaften aufweist. Aufgrund seiner 2D-Struktur weist es zudem eine hohe Leitfähigkeit auf.

Molybdändisulfid (MoS2) ist eine Bezeichnung für Molybdän(IV)-sulfid, ein kristallines Sulfid des chemischen Elements Molybdän. MoS2 ist ein Übergangsmetall-Dichalkogenid. Für dieses Material konnten die Erfinder überraschend feststellen, dass sich durch Auswahl der Schichtdicke der dielektrischen Schicht aus MoS2, die Schwellenspannung des herzustellenden Feldeffekttransistors, und somit eine Dotierung der Kanalschicht, besonders präzise durchführen lässt. Der erwähnte Schichtdicken-Schwellenspannung Proportionalzusammenhang ist hierbei besonders ausgeprägt.

Nach einer weiteren Ausgestaltung der Erfindung kann vorgesehen sein, dass die Source und Drain jeweils eine oder mehrere Lagen aus einem Metall umfassen, wobei das Metall einer jeweiligen Lage ausgewählt ist aus Pt, Pd, Ni und/oder Al.

An den Grenzflächen können sich Legierungen oder anderweitige metallische Mischphasen bilden. Es ist auch vorstellbar die Source und Drain aus nur einer Lage eines reinen Metalls oder Mischmetalls (z. B. aus Pt, Pd, Ni und/oder Al ) zu bilden. Es können auch andere Metalle vorgesehen sein.

Nach einer weiteren Ausgestaltung der Erfindung kann vorgesehen sein, dass die Schichtdicke (d) der dielektrischen Schicht ausgewählt wird aus einem Wertebereich von 1 nm bis 20 nm, bevorzugt von 1 nm bis 15 nm, wobei die Schichtdicke (d) besonders bevorzugt einen Wert von 1 nm, 2 nm, 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm oder einem dazwischen liegenden Wert annimmt. Für die angegebenen Schichtdickenbereiche bzw. Schichtdicken ist der Schichtdicken-Schwellenspannung Proportionalzusammenhang besonders ausgeprägt.

Die vorliegende Erfindung betrifft - wie schon eingangs erwähnt - einen Feldeffekttransistor, umfassend eine auf einem Substrat angeordnete Kanalschicht aus einem 2D-Material, eine Source und Drain, wobei die Source und Drain an die Kanalschicht angrenzend angeordnet sind, eine dielektrische Schicht aus einem High-k-Material umfassend Aluminiumoxynitrid, die auf einer dem Substrat abgewandten Seite der Kanalschicht angeordnet ist, sowie ein Gate. Der Feldeffekttransistor zeichnet sich dadurch aus, dass dieser nach einem Verfahren gemäß der Erfindung hergestellt ist.

Insbesondere betrifft die vorliegende Erfindung daher einen Feldeffekttransistor, umfassend eine auf einem Silizium Substrat mit einer darauf angeordneten SiO2-Schicht angeordnete Kanalschicht aus einem 2D-Material, wobei das 2D-Material Graphen oder Molybdändisulfid umfasst, eine Source und Drain, wobei die Source und Drain an die Kanalschicht angrenzend angeordnet sind, eine dielektrische Schicht aus einem High-k-Material aus Aluminiumoxynitrid ist, wobei die dielektrische Schicht auf einer dem Substrat abgewandten Seite der Kanalschicht angeordnet ist, sowie ein Gate direkt auf der dielektrischen Schicht aus Aluminiumoxynitrid, wobei eine Schwellenspannung des Feldeffekttransistors im Herstellungsprozess des Feldeffekttransistors eingestellt wird durch Aufbringen der dielektrischen Schicht in einer Schichtdicke, wobei die Schichtdicke zu einer gewünschten Schwellenspannung auf Basis eines Schichtdicken-Schwellenspannung Proportionalzusammenhangs korrespondiert.

Der Feldeffekttransistor kann durch jegliche Merkmale der vorliegenden Offenbarung ausgestaltet werden, insbesondere auch mit jenen im Kontext des beschriebenen Verfahrens diskutierten Merkmale.

Weitere Ausgestaltungen der Erfindung sind in den Zeichnungen angegeben.

Diese zeigen in
- Fig. 1: eine schematische Darstellung des grundsätzlichen Aufbaus eines Feldeffekttransistors nach einem ersten Ausführungsbeispiel der Erfindung in einer Explosionsdarstellung;
- Fig. 2: eine schematische Darstellung des Feldeffekttransistors nach Fig. 1 in einem zusammengebauten Zustand;
- Fig. 3: eine schematische Darstellung von Verfahrensschritten, die bei der Herstellung eines Feldeffekttransistors nach dem ersten Ausführungsbeispiel ausgeführt werden;
- Fig. 4: eine schematische Darstellung des grundsätzlichen Aufbaus eines Feldeffekttransistors nach einem zweiten Ausführungsbeispiel der Erfindung in einer Explosionsdarstellung;
- Fig. 5: eine schematische Darstellung des Feldeffekttransistors nach Fig. 4 in einem zusammengebauten Zustand;
- Fig. 6: eine schematische Darstellung von Verfahrensschritten, die bei der Herstellung eines Feldeffekttransistors nach dem zweiten Ausführungsbeispiel ausgeführt werden;
- Fig. 7, 8: experimentelle Untersuchungsergebnisse eines nach dem ersten Ausführungsbeispiel gefertigten Feldeffekttransistors;
- Fig. 9: experimentelle Untersuchungsergebnisse eines nach dem zweiten Ausführungsbeispiel gefertigten Feldeffekttransistors.

### ERSTES AUSFÜHRUNGSBEISPIEL

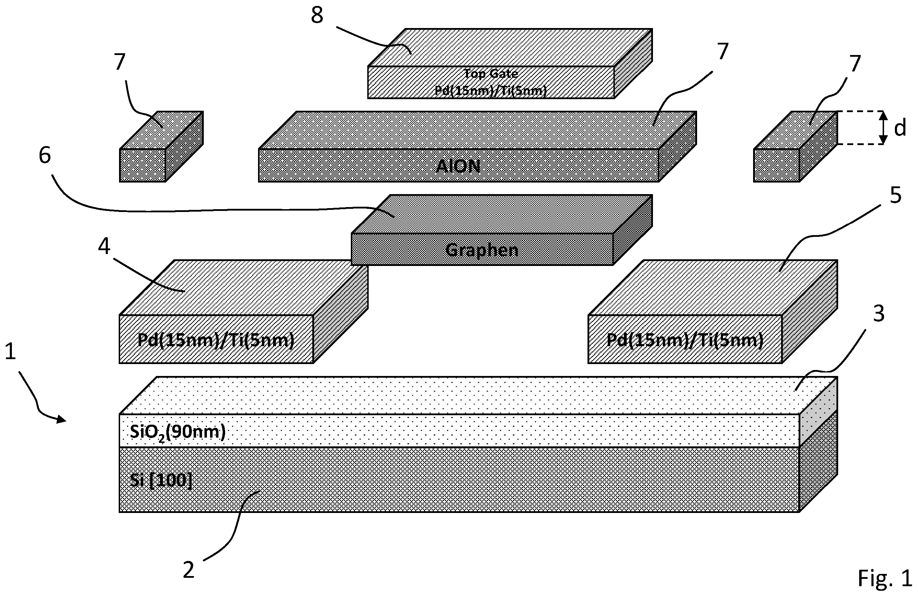

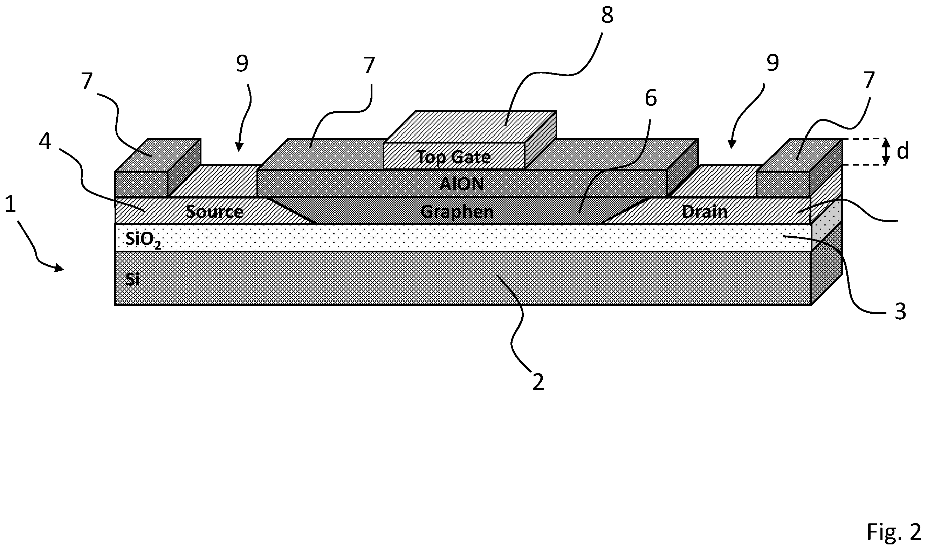

In der Figur 1 ist eine schematische Darstellung des grundsätzlichen Aufbaus eines Feldeffekttransistors nach einem ersten Ausführungsbeispiel der Erfindung dargestellt, nämlich in einer Explosionsdarstellung. Figur 2 zeigt eine schematische Ansicht der Komponenten des Feldeffekttransistors in einem zusammengebauten Zustand.

Erkennbar weist der Feldeffekttransistor zunächst ein Substrat 1 auf. Das Substrat 1 umfasst dabei zunächst eine Si-Schicht 2 (also eine Schicht aus Silizium mit einer Kristallanordnung [100]). Auf der Si-Schicht 2 ist eine SiO₂-Schicht 3 (z. B. in einer Schichtdicke von 90 nm) angeordnet. Auf dem Substrat 1, konkret auf der SiO₂-Schicht 3, ist eine Source 4 und ein Drain 5 angeordnet, wobei sowohl Source 4 und Drain 5 in Form von Titan/Palladium Kontakten ausgebildet sind. Beispielsweise können Source 4 und Drain 5 eine Lage Palladium in einer Schichtdicke von 15 nm und eine Lage Titan in einer Schichtdicke von 5 nm aufweisen. Zwischen Source 4 und Drain 5 ist die Kanalschicht 6 aus Graphen als 2D-Material angeordnet. Auf der Source 4, der Drain 5 sowie der Kanalschicht 6 ist eine dielektrische Schicht 7 aus einem High-k Material, konkret Aluminiumoxynitrid (kurz: AION), angeordnet. Die dielektrische Schicht 7 ist somit auf einer dem Substrat 1 abgewandten Seite der Kanalschicht 6 angeordnet. Ferner ist auf der dielektrischen Schicht 7 ein Gate 8, nämlich ein Top-Gate aus Titan/Palladium (Schichtdicken für Pd = 15 nm und Ti = 5 nm) angeordnet. In der dielektrischen Schicht 7 sind Lochöffnungen 9 (vgl. Fig. 2) ausgebildet, durch welche die Source 4 und Drain 5 elektrisch kontaktiert werden können.

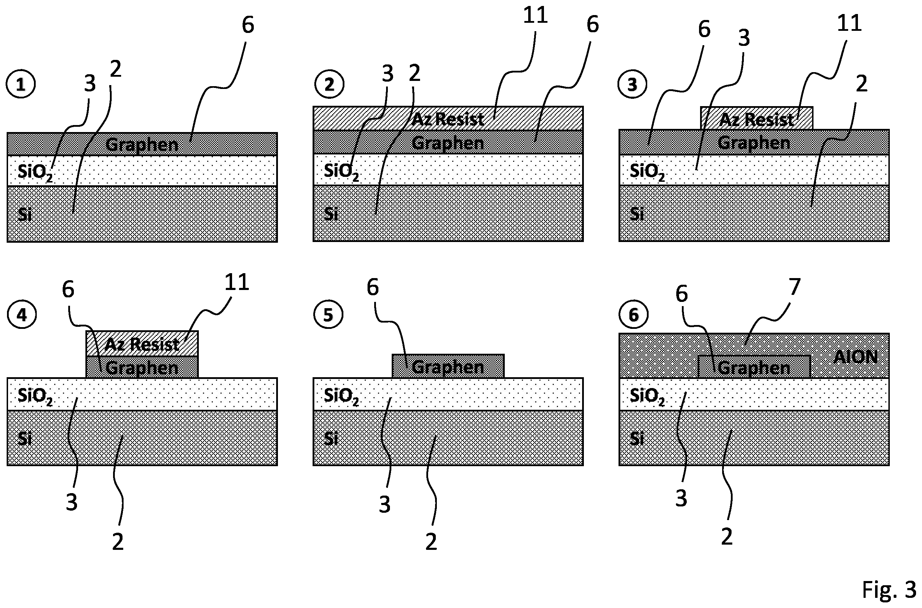

Der Feldeffekttransistor gemäß dem ersten Ausführungsbeispiel wurde von den Erfindern gemäß der folgenden Experimentalbeschreibung gefertigt, vgl. auch die Schritte 1 bis 6 in Fig. 3: Als Substrate 1 wurden 2x2 cm² große Siliziumsubstrate mit 90 nm (Schichtdicke) thermisch aufgewachsenem SiO₂ zur Ausbildung der SiO₂-Schicht 3 verwendet. 5 nm/15 nm Titan/Palladium-Bodenkontakte wurden auf den Proben durch Elektronenstrahlverdampfung und Lift-off-Verfahren abgeschieden. Diese Bodenkontakte stellen die Source 4 und Drain 5 bereit. Kommerzielles CVD-Graphen auf Kupfer wurde nass geätzt und das Graphen wurde manuell auf das Substrat übertragen (transferiert). Die Graphen umfasse Kanalschicht 6 wurde durch Strukturieren gebildet, nämlich durch reaktives Ionenätzen (RIE). Die dielektrische Schicht 7 (hier aus Aluminiumoxynitrid = AION) wurde in unterschiedlichen Proben in Schichtdicken d von 7, 12 und 17 nm durch ein PEALD Verfahren bei 200 °C in einem Stickstoffplasmaverfahren mit geringer Leistung unter Verwendung von Trimethylaluminium als Vorläufer abgeschieden.

Sodann wurden Ti/Pd-Top-Gates jeweils als Gate 8 durch Elektronenstrahlverdampfung und Lift-off bereitgestellt.

Das Graphen wurde während des Transfers mit einer Schutzschicht 10 aus einem Polymer (Polymethylmethacrylat = PMMA) bedeckt. Nachdem das Graphen auf das Substrat 1 übertragen (transferiert) worden ist, wurde die Schutzschicht 10 aus PMMA für eine Stunde lang in Aceton gelöst und die Probe dann vor dem Trocknen mit Isopropyl-Alkohol gespült (Fig. 3-1). Danach wurde ein lithografischer Prozess mit einer Schicht AZ-Resist 11 (also einem Fotoresist) verwendet, um die Kanalschicht 6 aus Graphen zu strukturieren (Fig. 3-2,3). Nach der Strukturierung durch reaktives Ionenätzen (Fig. 3-4) wurde die Schicht des AZ-Resist 11 eine Stunde lang in Aceton von dem Graphen abgelöst (Fig. 3-5). Das Erzeugnis wurde in Isopropyl-Alkohol gespült und getrocknet. Die dielektrische Schicht 7 wurde im Wege des PEALD Verfahrens mit einem Atomfab^{®} PEALD System der Fa. Oxford Instruments aufgebracht (Fig. 3-6).

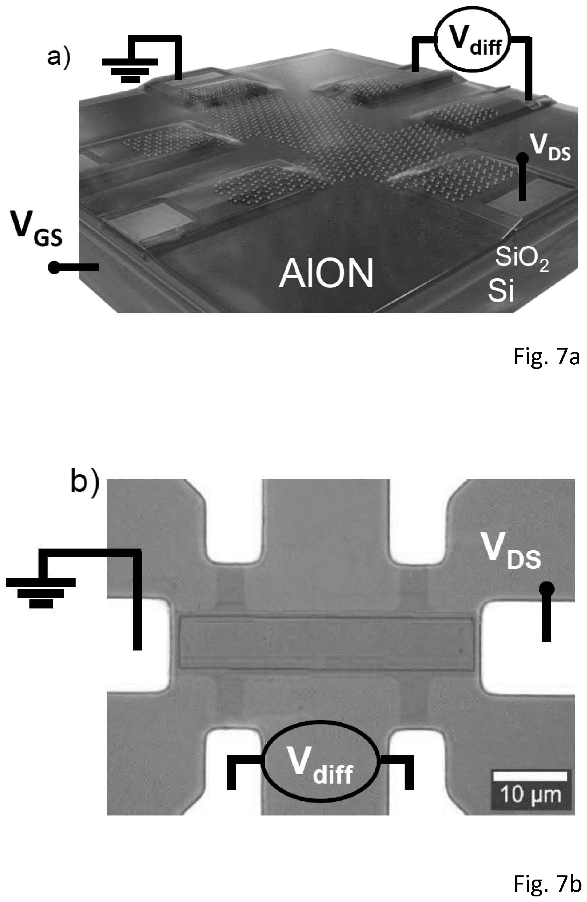

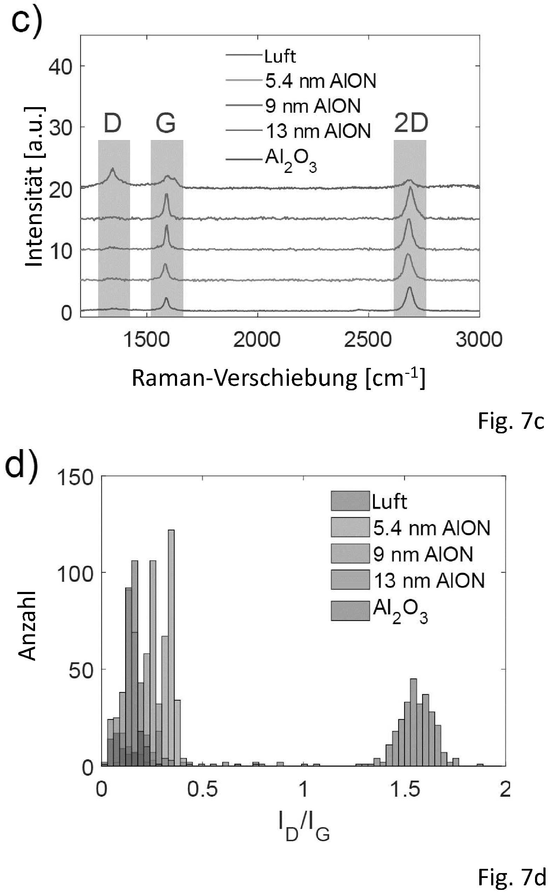

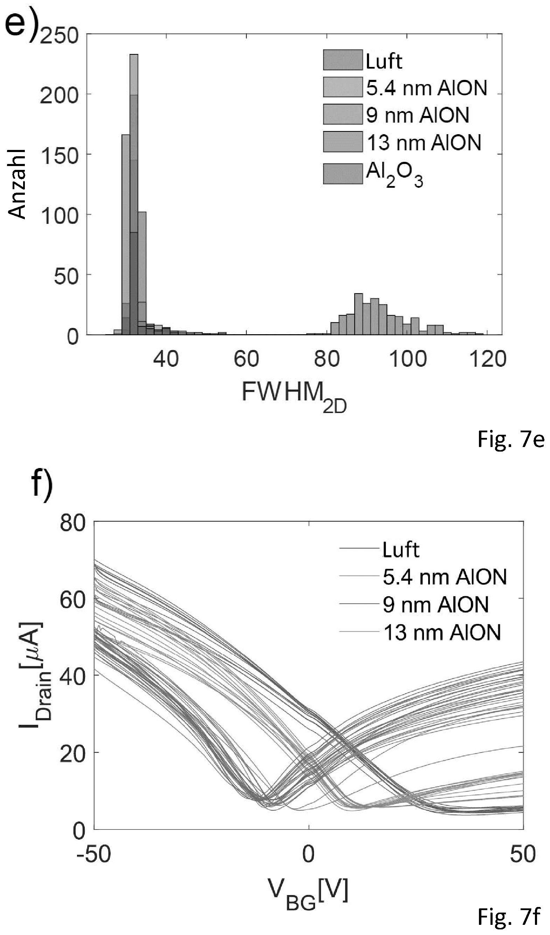

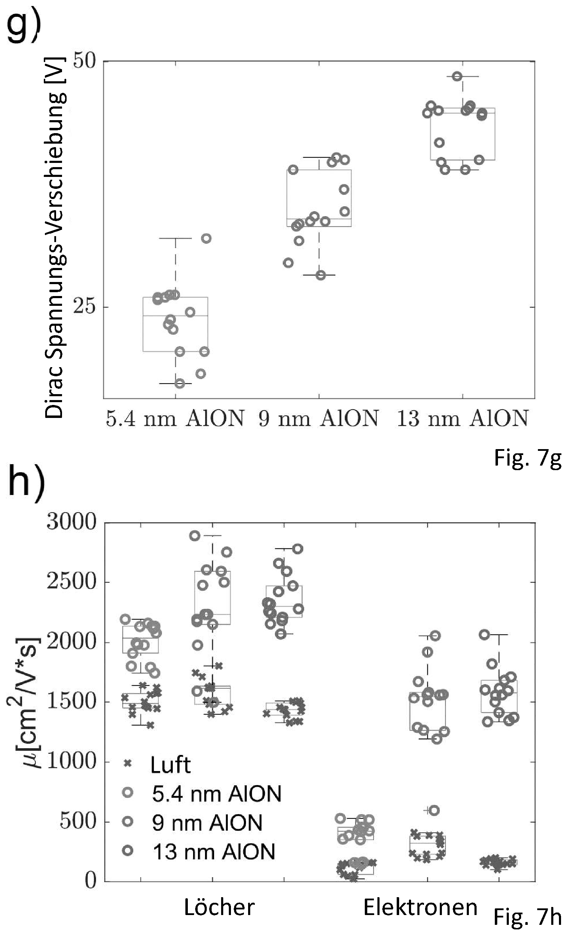

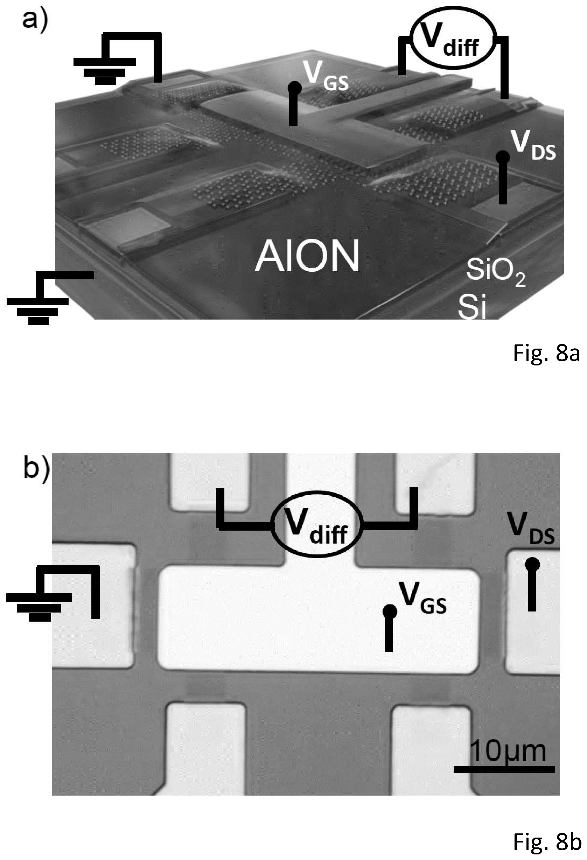

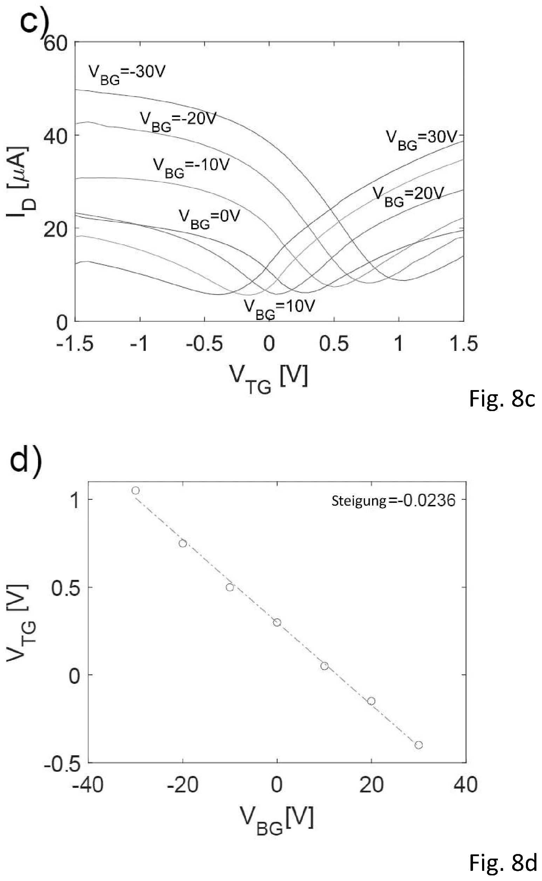

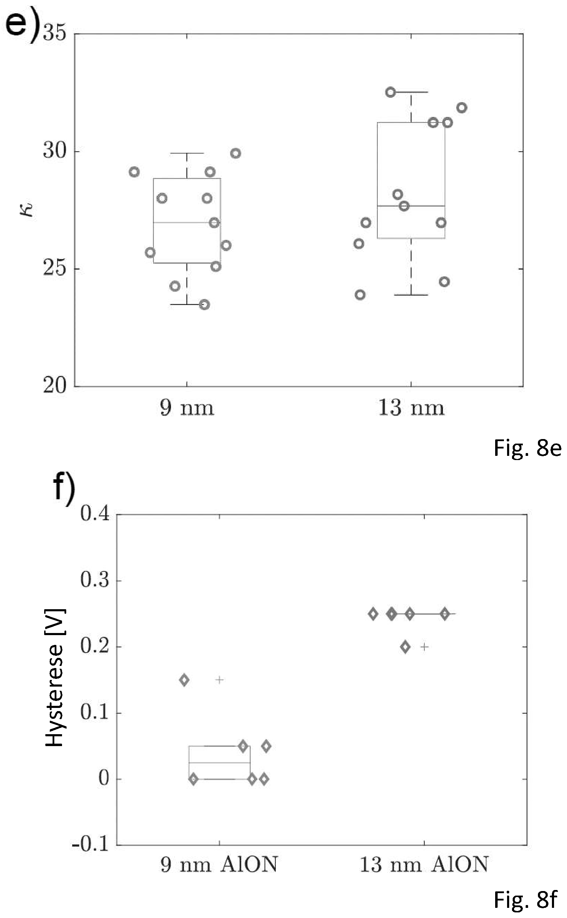

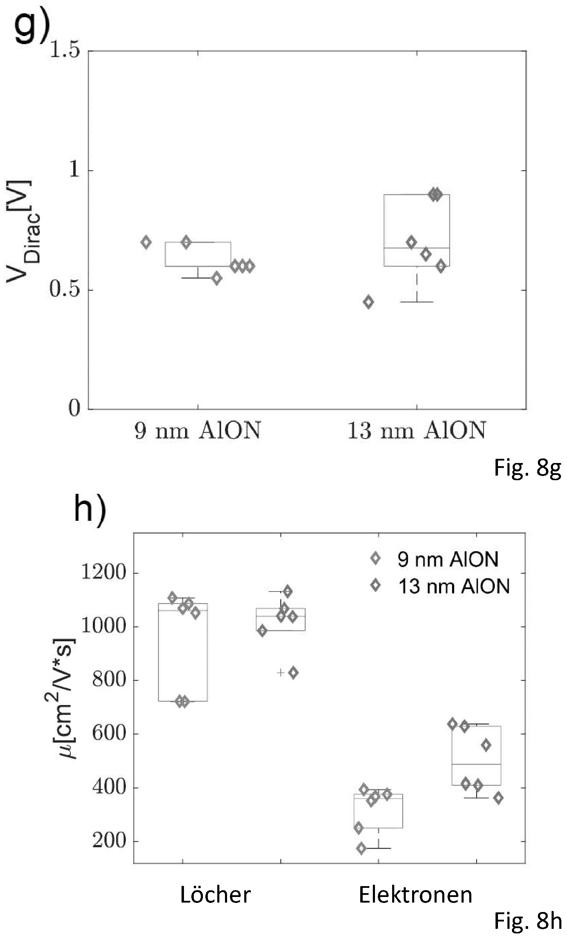

Der vorangehend beschriebene Grundaufbau eines Feldeffekttransistors nach dem ersten Ausführungsbeispiel der Erfindung wurde gemäß den in Fig. 7 und 8 angegebenen experimentellen Untersuchungen charakterisiert.

Dabei zeigt Fig. 7 a) ein Schema eines Back-Gate geschalteten Bauelements gemäß dem Grundaufbau eines Feldeffekttransistors nach der Erfindung in Vier-Punkt-Konfiguration mit Ti/Pd-Source- und Drain-Bodenkontakten und einer dielektrischen Aluminiumoxynitrid-Schicht. Figur 7 b) zeigt eine Wiedergabe des Back-Gate geschalteten Bauelements in Draufsicht. Das rote Rechteck stellt jenen Bereich dar, in dem Raman-Spektroskopie-Maps aufgenommen wurden. In den Figuren 7 c) bis e) ist eine Raman-Analyse von Graphen in Luft sowie nach Abscheidung von dielektrischen Aluminiumoxynitrid-Schichten in Schichtdicken d von 5 nm, 4nm , 9 nm und 13 nm im Vergleich zu Graphen nach der Abscheidung von Al₂O₃ gezeigt. Figur 7 c) zeigt dabei einzelne Raman-Spektren. Figur 7 d) zeigt das Verhältnis der Intensität des D-Peaks zur Intensität des G-Peaks. Figur 7 e) zeigt die gesamte Breite bei halbem Maximum (FWHM) des 2D Peaks. Die Figuren 7 e) bis f) zeigen einen Vergleich der elektrischen Daten aus der Konfiguration der Vier-Punkt-Messungen vor und nach der Abscheidung von dielektrischen Aluminiumoxynitrid-Schichten für Schichten in Schichtdicken von 5 nm, 4nm , 9 nm und 13 nm. Figur 7 f) zeigt Strom-Spannungs-Transferkurven. Figur 7 g) zeigt die gemessene Verschiebung der Dirac-Spannung aufgrund der Abscheidung der Aluminiumoxynitrid-Schicht, also der dielektrischen Schicht 7. Dies zeigt, dass die Schichtdicke d der dielektrischen Schicht proportional zur Verschiebung der Dirac-Spannung, und somit zur Schwellenspannung, ist. Figur 7 h) zeigt Löcher- und Elektronenmobilitäten.

### ZWEITES AUSFÜHRUNGSBEISPIEL

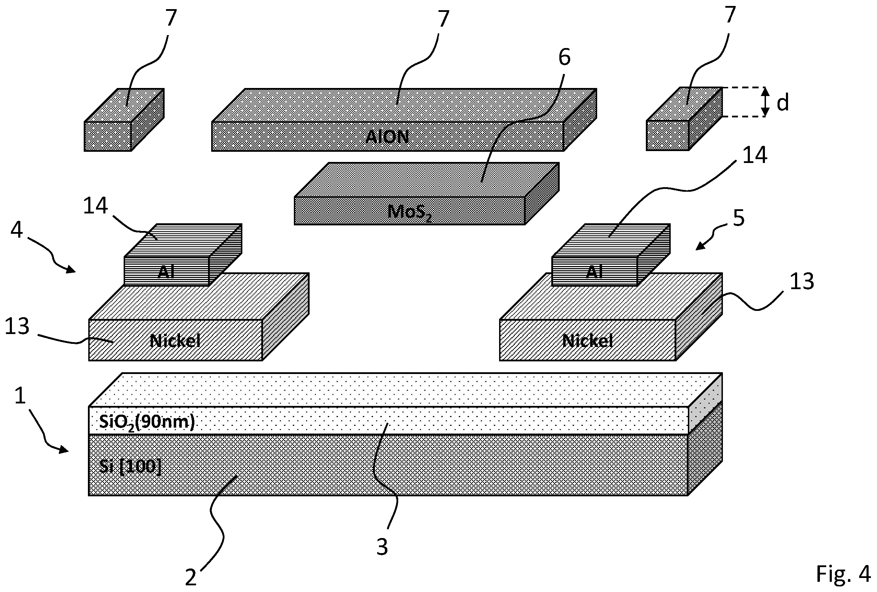

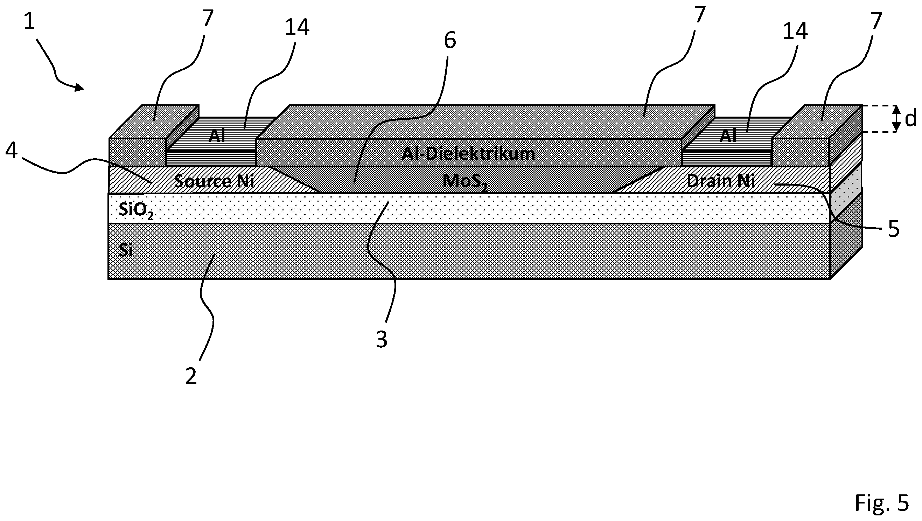

In der Figur 4 ist eine schematische Darstellung des grundsätzlichen Aufbaus eines Feldeffekttransistors nach einem zweiten Ausführungsbeispiel der Erfindung dargestellt, nämlich in einer Explosionsdarstellung. Figur 5 zeigt den Feldeffekttransistor in zusammengebautem Zustand, wobei offengelassen ist, ob dieser ein als Top-Gate oder Back-Gate geschaltetes Gate 8 aufweist. Der Feldeffekttransistor gemäß dem zweiten Ausführungsbeispiel unterscheidet sich im Wesentlichen vom Feldeffekttransistor gemäß dem ersten Ausführungsbeispiel dadurch, dass die Kanalschicht 6 aus einem anderen 2D-Material gebildet ist. Beim zweiten Ausführungsbeispiel ist die Kanalschicht 6 aus Molybdändisulfid (MoS2) gebildet, während das erste Ausführungsbeispiel auf eine Kanalschicht 6 aus Graphen zurückgreift. Sowohl MoS2 als auch Graphen sind 2D-Materialien.

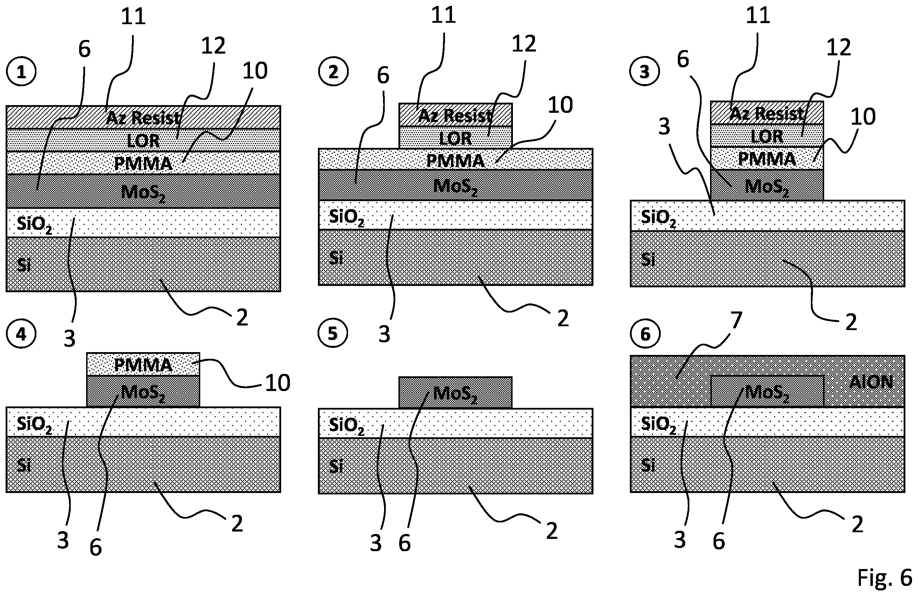

Der Feldeffekttransistor gemäß dem zweiten Ausführungsbeispiel wurde von den Erfindern gemäß der folgenden Experimentalbeschreibung gefertigt, vgl. auch die Schritte 1 bis 6 in Fig. 6: Als Substrate 1 wurden 2x2 cm² große Siliziumsubstrate mit 90 nm (Schichtdicke) thermisch aufgewachsenem SiO₂ (SiO₂-Schicht 3) verwendet. 15 nm Nickel-Bodenkontakte 13 wurden auf den Proben durch Sputtern und Lift-Off abgeschieden, dann wurde eine zusätzliche 50-nm dicke Aluminiumschicht 14 auf den Kontaktflächen der Nickel-Bodenkontakte 13 durch Elektronenstrahlverdampfung und Lift-Off abgeschieden. Die Nickel-Bodenkontakte 13 bilden gemeinsam mit den Aluminiumschichten 14 die Source 4 und Drain 5 aus. MOCVD-gewachsenes MoS2 auf Saphir wurde vom Wachstumssubstrat delaminiert und das MoS2 wurde manuell auf das Substrat 1 übertragen (transferiert). Die Kanalschicht 6 aus MoS2 wurde durch reaktives Ionenätzen (RIE) strukturiert. Die dielektrische Schicht 7 auf Aluminiumbasis (Aluminiumoxynitrid) wurde in unterschiedlichen Proben mit Schichtdicken d von 3, 6, 8 und 17 nm durch PEALD bei 200 °C in einem Stickstoffplasmaverfahren mit geringer Leistung unter Verwendung von Trimethylaluminium als Vorläufer abgeschieden.

Das MoS2 wurde während des Transfers mit einer Schutzschicht 10 Polymerschicht (PMMA) geschützt. Sobald das MoS2 auf das endgültige Substrat 1 übertragen (transferiert) wurde, verblieb die Schutzschicht 10 auf der Probe. Sodann wurden zwei zusätzliche Schichten (LOR 12, also ein Lift Off Resist, sowie AZ-Resist 11, also ein Fotoresist) auf die Probe aufgetragen (Fig. 6-1) und eine Lithografie durchgeführt (Fig. 6-2). Die PMMA- und die MoS2-Schicht wurden beide durch reaktives Ionenätzen geätzt (Fig. 6-3). Die oberen Schichten (LOR 12 + AZ-Resist 11) wurden dann durch eine Kombination aus UV-Belichtung und Spülen in Entwickler entfernt, während die Schutzschicht 10 aus PMMA auf dem MoS2 verblieb (Fig. 6-4). Die Probe wurde bei hoher Temperatur getempert, um das PMMA vollständig vom MoS2 zu verdampfen und eine saubere, rückstandsfreie Oberfläche zu erhalten (Fig. 6-5). Die dielektrische Schicht 7 wurde dann im Wege des PEALD Verfahrens mit einem Atomfab^{®} PEALD System der Fa. Oxford Instruments aufgebracht (Fig. 6-6).

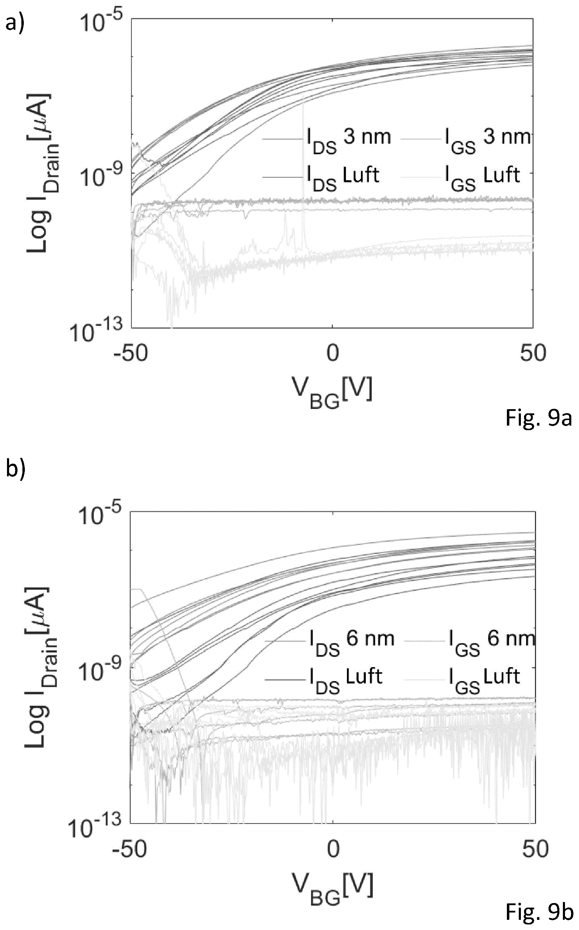

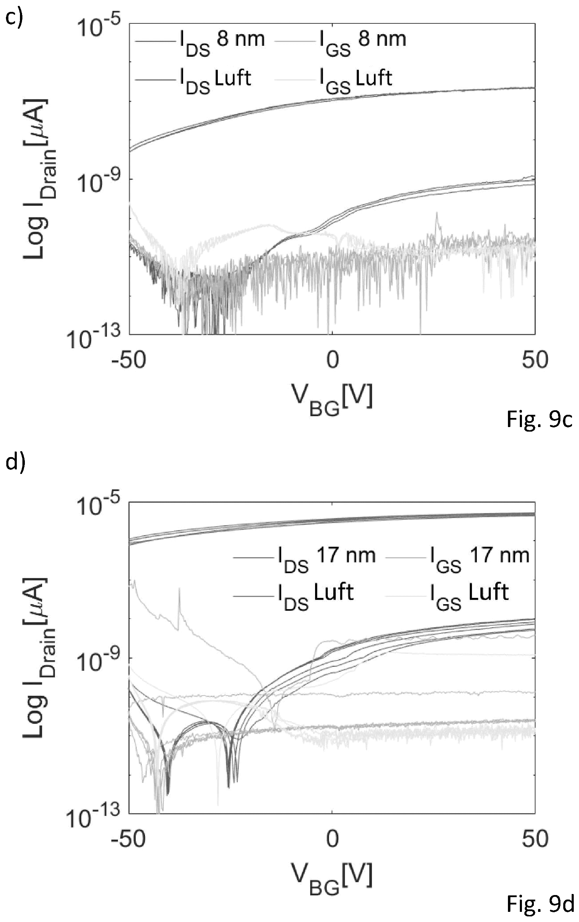

Der vorangehend beschriebene Grundaufbau eines Feldeffekttransistors nach dem zweiten Ausführungsbeispiel der Erfindung wurde gemäß den in Fig. 9 angegebenen experimentellen Untersuchungen charakterisiert. Die Figuren 9 a) bis d) zeigen Strom-Spannungs-Transferkurven, wobei die Ordinate logarithmiert dargestellt ist. Je größer die Schichtdicke, desto stärker die anhand des Spannungs-Shifts erkennbare Dotierung. Der Spannungs-Shift ist proportional zu einer Verschiebung der Schwellenspannung. Somit ist die Schichtdicke der dielektrischen Schicht 7 proportional zur Schwellenspannung. Die Charakterisierung wurde für Schichtdicken der dielektrischen Schicht von 3 nm, 6 nm, 8 nm und 17 nm jeweils im Vergleich zu Luft durchgeführt.

### Bezugszeichenliste

- 1: Substrat
- 2: Si-Schicht
- 3: SiO₂-Schicht
- 4: Source
- 5: Drain
- 6: Kanalschicht
- 7: dielektrische Schicht
- 8: Gate
- 9: Lochöffnung
- 10: Schutzschicht
- 11: AZ Resist
- 12: LOR
- 13: Nickel-Bodenkontakt
- 14: Aluminiumschicht
- d: Schichtdicke

## Patentansprüche

1. Feldeffekttransistor, umfassend eine auf einem Silizium Substrat (1) mit einer darauf angeordneten SiO2-Schicht angeordnete Kanalschicht (6) aus einem 2D-Material, wobei das 2D-Material Graphen oder Molybdändisulfid umfasst, eine Source (4) und Drain (5), wobei die Source (4) und Drain (5) an die Kanalschicht (6) angrenzend angeordnet sind, eine dielektrische Schicht (7) aus einem High-k-Material aus Aluminiumoxynitrid, die auf einer dem Substrat (1) abgewandten Seite der Kanalschicht (6) angeordnet ist, sowie ein Gate (8), welches direkt auf der dielektrischen Schicht (7) aus Aluminiumoxynitrid angeordnet ist.
